Europäisches Patentamt

European Patent Office

Office européen des brevets

(11) Publication number: **0 499 084 A1**

# EUROPEAN PATENT APPLICATION

(21) Application number: **92101374.4**

(22) Date of filing: **28.01.92**

(51) Int. Cl.5: **H01L 21/00**

(30) Priority: **05.02.91 JP 10385/91**

(43) Date of publication of application:
**19.08.92 Bulletin 92/34**

(84) Designated Contracting States:
**DE FR GB IT**

(71) Applicant: **ENYA SYSTEMS LIMITED**
**8-36, Yoshinodai 2-chome**
**Kawagoe-shi, Saitama-ken(JP)**

(72) Inventor: **Yokosuka, Noriyoshi**
**2-403, 8-1, Kuboinari 1-chome**
**Iruma-shi, Saitama-ken(JP)**

(74) Representative: **Klingseisen, Franz, Dipl.-Ing.**
**et al**
**Dr. F. Zumstein Dipl.-Ing. F. Klingseisen**
**Bräuhausstrasse 4**
**W-8000 München 2(DE)**

(54) **Wafer mount plate.**

(57) A wafer mount plate which is used repeatedly, is constructed such that plural wafers can always be mounted at the same positions of the mount plate. At a part of the mount plate body, an identifier is embedded such that it can be identified from the outside. The mount plate is placed on a support rotated for indexing, and the wafers are mounted on the upper surface thereof by a wafer mounting means. The wafer-mounted positions on the mount plate and the position of the wafer mounting means are always brought into the same relation by detecting the position of the identifier with a sensor. The identifier does not disappear even if the surface of the mount plate is ground.

FIG. 1

## BACKGROUND OF THE INVENTION

### (1) Field of the Invention

The present invention relates to a wafer mount plate used for making the flat surface of a wafer by polishing in the production of a semiconductor or the like.

### (2) Background Information

In the production of a semiconductor, it is required to make the wafer extremely flat by polishing with a polishing machine to obtain a semiconductor device having a high degree of integration. For this purpose, plural wafers are mounted on the mount plate of the polishing machine with an adhesive by an automatic mounting apparatus. Since the polishing is made through various steps, the mount plate is made of a material which is chemically anti-corrosive and shows less deformation against aged deterioration or a load. In general, a ceramic or a glass such as Pyrex (trade name) is used as such a material.

The mount plate is supplied to the automatic mounting apparatus of the wafers. Plural wafers are mounted thereon. Upon the completion of the polishing, the wafers are demounted from the mount plate. After the adhesive or the like adhered to the surface of the plate is removed by cleaning, the plate is supplied to the automatic mounting apparatus again and used repeatedly.

The wafers are polished as mentioned above, but the wafer-mounting surface of the mount plate sometimes undergoes minute changes by use. For example, a mechanochemical polishing is a method wherein particles, which are softer than a workpiece, are used as a material corresponding to the particles in the polishing, a solid-phase reaction is caused between the particles and the workpiece, such a reaction at the contact surfaces thereof forms a foreign material and the polishing proceeds while removing such a material. In such a case, since a chemical reaction is used, the portions on which the wafers are not mounted are affected thereby more or less, and it is difficult to say that the portions undergo no change in their properties. On the other hand, since the portions on which the wafers are mounted undergo such a change slightly, the mount plate shows different changes of the surface conditions between the wafer-mounted portions and the no wafer-mounted portions, and therefore an uneven surface is formed. Thus, if the position on which the wafers are mounted is changed, it becomes impossible to mount the wafers uniformly. Therefore, when the plate is used in a predetermined number of times, its surface is generally ground thinly, for example, about several tens microns to remove the unevenness of the surface.

## SUMMARY OF THE INVENTION

An object of the present invention is to provide a wafer mount plate which enables to mount wafers always at the same positions when the wafers are automatically mounted on the mount plate by a mounting apparatus.

Another object of the present invention is to provide a wafer mount plate which enables to set wafer-mounted positions always at the same positions even if the surface of the mount plate is ground thinly.

According to the present invention, the above objects can be accomplished by providing a wafer mount plate which comprises a disk shape body having a mount surface on which a wafer is mounted, and an identifier for positioning which is embedded in the body for indexing the position on which the wafer is mounted.

The mount plate is supplied to the automatic wafer mounting apparatus, and placed on a supporting portion of an indexing means. The position of the mount plate is compensated by rotating the support to a predetermined position by use of a sensor arranged at a predetermined position and the identifier arranged at the mount plate. Thus, the mount plate is always placed at the normal position to the mounting means of the wafers, and the wafers are always mounted at the same positions.

The other objects and features of the present invention will be apparent from the following description referring to the attached drawings.

## BRIEF DESCRIPTION OF THE DRAWINGS

Fig. 1 is a perspective view showing the situation wherein a wafer mount plate of the present invention is placed on a support of an indexing means.

Fig. 2 is an enlarged sectional view of a portion in which an identifier is embedded.

Fig. 3 is an enlarged side view of a part of a wafer mount plate wherein an identifier is provided.

## DESCRIPTION OF THE PREFERRED EMBODIMENTS

A mount plate body 1 is formed into a disk shape with use of a ceramic material, a glass material such as Pyrex (trade name) or the like, and has on its upper surface a mount surface 3 used for mounting a wafer 2. At an appropriate position of the body 1, for example, at the central portion or the peripheral portion of the mount surface 3, an identifier 4 is provided. The identifier 4 is made of a material whose properties are hardly changed chemically, and is embedded in the body so that it will not disappear even if the surface of the body is ground thinly. For example, an identifier made of a ceramic material or a glass material having a different color from that of the body may be embedded at a part of the body.

The above identifier 4 may be merely a mark. However, for controlling the mount plate, it is preferred to form an individual marker such as Arabic numerals, European numerals or bar code indications.

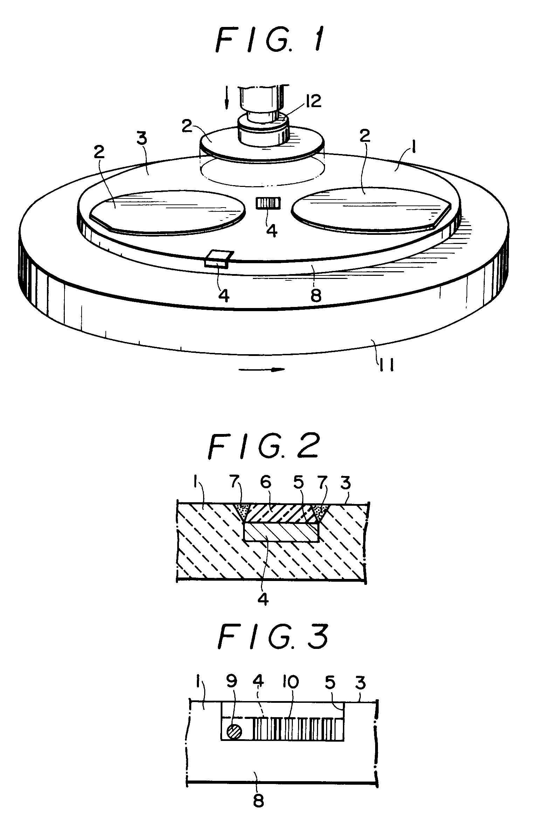

Fig. 2 shows an enlarged sectional view of a part in which an identifier is embedded. In this figure, at a part of the body 1, a concave portion 5 is formed so that it extends to the side surface of the periphery. An identifier 4 provided with an appropriate marker is inserted in the concave portion 5. A covering material 6 such as a ceramic material or a glass material having the transparency is provided thereon, and is adhered to the body with an adhesive 7. Their surfaces are formed at the same level as the surface 3 of the body. In this instance, the marker of the identifier 4 may be provided at the side of the mount surface 3 and the side of the side surface 8 of the mount plate. Also, the concave portion may be wholly filled with a substance made of the above material having the transparency.

As mentioned above, the identifier 4 embedded in the body 1 does not disappear even if the surface of the body is ground thinly, and can be seen from the outside as shown in Fig. 3. The identifier 4 as shown in Fig. 3 is provided with a mark 9 for positioning and also a bar code 10 for controlling. However, the outer bar of the bar code 10 may be used as a positioning mark without providing the mark 9 for positioning.

The mount plate 1 thus constructed is placed on a support 11 in which the position for mounting the wafer 2 can be controlled by an indexing means (not shown in the drawing), and held by a vacuum action. Before the mounting, the support 11 is rotated and the identifier 4 is detected by a sensor (not shown in the drawing) provided at an appropriate position to fit correctly the position of the wafer mounting means 12 to the position of the mount plate 1. Then, the wafer mounting means 12 is lowered, and the wafer 2 having an adhesive previously applied thereon is mounted on the mount plate 1. After the wafer is mounted on the mount plate, the mounting means is lifted up and receives the next wafer. In the interim, the support 11 is rotated at a predetermined angle by the indexing means to rotate the mount plate to the position where the next wafer is mounted. Then, predetermined numbers of wafers are always mounted at the same positions of the mount plate as mentioned above.

As described above, according to the present invention, it is possible to fit securely the mount plate to the position of the wafer mounting means, and to mount the wafers always on the mount surface of uniform conditions. Thus, wafers having a high flatness can be obtained, and the identifier does not disappear even if the mount plate is ground thinly and can be used for a long period of time. In addition, since the bar code or the like can be used as the identifier, the control of the mount plate can be made readily.

**Claims**

1. A wafer mount plate which comprises a disk shape body having a mount surface on which a wafer is mounted, characterised in that an identifier (4) for positioning which is embedded in said body (1) is provided for indexing the position on which the wafer is mounted.

2. The wafer mount plate according to Claim 1, wherein the identifier (4) is formed in a concave portion (5) formed at a part of the body, the upper surface of said identifier (4) is provided with a transparent covering material (6), and the surface of said covering material (6) is formed such that the surface is at the same level with the surface of the body.

3. The wafer mount plate according to Claim 1, wherein the identifier (4) is represented by a bar code (10).

4. The wafer mount plate according to Claim 1, wherein the identifier (4) is provided at the periphery (8) of the body (1).

# F I G. 1

# F I G. 2

# F I G. 3

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | US-A-4 960 485 (ICHINOSE)<br>* column 9, line 25 - line 52; figures 12-14 *<br>--- | 1 | H01L21/00 |
| A | US-A-4 744 713 (HROVATH)<br>* claims 1,6; figure 1 *<br>----- | 1 | |
| | | | **TECHNICAL FIELDS SEARCHED (Int. Cl.5)**<br><br>H01L<br>B24B |

The present search report has been drawn up for all claims

| Place of search | Date of completion of the search | Examiner |
|---|---|---|
| THE HAGUE | 13 MAY 1992 | RIEUTORT A.S. |

EPO FORM 1503 03.82 (P0401)